# Europäisches Patentamt

# European Patent Office

# Office européen des brevets

(19)

(11) Veröffentlichungsnummer: **0 200 080**
**B1**

(12) ## EUROPÄISCHE PATENTSCHRIFT

(45) Veröffentlichungstag der Patentschrift:
**18.07.90**

(51) Int. Cl.5: **G01R 33/035**

(21) Anmeldenummer: **86105133.2**

(22) Anmeldetag: **14.04.86**

(54) Vorrichtung zur Messung schwacher Magnetfelder mit wenigstens einem DC-SQUID.

(30) Priorität: **26.04.85 DE 3515237**

(43) Veröffentlichungstag der Anmeldung:
**10.12.86 Patentblatt 86/45**

(45) Bekanntmachung des Hinweises auf die Patenterteilung:
**18.07.90 Patentblatt 90/29**

(84) Benannte Vertragsstaaten:
**DE FR IT NL**

(56) Entgegenhaltungen:
**EP-A- 0 111 827**

**CRYOGENICS, Band 23, Nr. 5, Mai 1983, Seiten 263-264, Butterworth & Co. (Publishers) Ltd., Guildford, Surrey, GB; S.I. BONDARENKO et al.: "A planar thin-film SQUID of high inductive coupling constant"**
**REVIEW OF SCIENTIFIC INSTRUMENTS, Band 55, Nr. 6, Juni 1984, Seiten 952-957, New York, US; F. WELLSTOOD et al.: "Integrated dc SQUID magnetometer with a high slew rate"**

(73) Patentinhaber: **Siemens Aktiengesellschaft, Wittelsbacherplatz 2, D-8000 München 2(DE)**

(72) Erfinder: **Hoenig, Eckhardt, Dr., Palmstrasse 1a, D-8520 Erlangen(DE)**

**Beschreibung**

Die Erfindung bezieht sich auf eine Vorrichtung zur mehrkanaligen Messung schwacher Magnetfelder, welche Vorrichtung ein Gradiometer-Feld mit einer Vielzahl von Gradiometern sowie ein an das Gradiometer-Feld angekoppeltes, auf einem Substrat befindliches Interferometer-Feld mit einer Vielzahl von supraleitenden Gleichstrom-Quanteninterferometern enthält, die jeweils zwei Josephson-Kontakte aufweisen und denen jeweils eine Koppelspule sowie eine Modulationsspule zugeordnet sind. Eine derartige Meßvorrichtung geht aus der EP-A 0 111 827 hervor.

Es ist bekannt, zur Messung schwacher, sich ändernder Magnetfelder, beispielsweise in einem Feldstärkebereich unter $10^{-10}$ T, insbesondere unter $10^{-12}$ T, supraleitende Quanteninterferometer zu verwenden, die bekannt sind unter der Bezeichnung "SQUID" (superconducting quantum interference device). Diese Interferometer werden vorzugsweise verwendet in der medizinischen Technik, insbesondere in der Magnetokardiographie, bei der Magnetfelder des Herzens in der Größenordnung von etwa 50 pT gemessen werden, sowie in der Magnetoenzephalographie, bei dem Magnetfelder des Gehirns in der Größenordnung von etwa 0,1 pT zu messen sind. Die Vorrichtung besteht im wesentlichen aus einer Detektorspule, die zusammen mit einer Koppelspule einen Flußtransformator bildet. Dem Interferometer ist zur Signalerfassung und -verarbeitung eine Elektronik zugeordnet. Da die zu messenden Magnetfelder bis zu sechs Größenordnungen kleiner sind als äußere Störfelder, sind entsprechende Abschirmungen erforderlich. Wegen seiner größeren Empfindlichkeit kann ein nachfolgend auch als DC-SQUID (direct-current-SQUID) bezeichnetes Gleichstrom-Quanteninterferometer verwendet werden, das zwei Josephsonkontakte enthält. Die Detektorspule bildet mit einer zugeordneten Kompensationsspule ein sogenanntes Gradiometer. Mit Gradiometern nullter, erster oder höherer Ordnung kann das im Gradiometerbereich noch inhomogene biomagnetische Nahfeld selektiv erfaßt werden (Rev. Sci. Instrum. 53 (12), Dec. 1982, Seiten 1815 bis 1845).

Eine Ausführung des DC-SQUIDs mit der zugeordneten Koppelspule als Dünnfilmtransformator, bei dem die flachen spiralförmigen Windungen der Koppelspule über dem SQUID angeordnet sind, ergibt eine gute magnetische Kopplung und einen geringen Raumbedarf. Eine Koppelspule mit 100 Windungen benötigt beispielsweise nur etwa 2 mm² (IEEE Transactions on Magnetics, Vol. MAG-17, No. 1, Jan. 1981, Seiten 400 bis 403).

Ein planares Dünnfilm-SQUID mit einer hohen induktiven Koppelkonstanten ist der Veröffentlichung "Cryogenics", Mai 1983, Seiten 263 bis 264 zu entnehmen. Bei diesem SQUID ist zur Reduktion der Induktivität der SQUID-Schleife eine sogenannte Groundplane vorgesehen. Hierbei handelt es sich um eine weitgehend ebene, flächenhafte Dünnfilmstruktur, die gegenüber den Teilen des SQUIDs isoliert ist und auf beliebigen Potential liegt. Die Koppelkonstante ist dabei abhängig von der Lage dieser Groundplane bzgl. einer Koppelspule, die im wesentlichen parallel zu der SQUID-Schleife angeordnet ist.

Um eine räumliche Feldverteilung zu erhalten, muß zeitlich nacheinander an verschiedenen Orten des zu untersuchenden Bereiches gemessen werden. Dann besteht aber die Schwierigkeit, daß über die dazu erforderliche Meßzeit die Kohärenz der Felddaten nicht mehr gegeben ist und sich außerdem klinisch unzumutbare Meßzeiten ergeben. Mit einer bekannten Vorrichtung, die mehrere parallele Meßkanäle mit jeweils einem supraleitenden Radiofrequenz-Quanteninterferometer (radio frequency SQUID) enthält, kann zwar im Prinzip die Meßzeit verkürzt werden (Physica 107 B (1981), Seiten 29, 30 North Holland Publ. Comp.); ein Feld von Gradiometern, dem wenigstens ein Feld von SQUIDs zugeordnet ist, kann jedoch mit dieser Ausführungsform nicht hergestellt werden. Entsprechende Felder werden vielfach auch als Arrays bezeichnet.

Eine vielkanalige Meßvorrichtung mit supraleitendem Gradiometer-Array und zugeordnetem SQUID-Array ist aus der eingangs genannten EP-A 0 111 827 bekannt. Das Gradiometer-Array soll dabei auf einer ebenen Trägerstruktur angeordnet sein, während sich das SQUID-Array auf einem eigenen Substrat (Si-Chip) befindet, das seinerseits auf der Trägerstruktur befestigt ist. Somit ergibt sich eine starre Verbindung zwischen SQUID-Array und Gradiometer-Array. Bei einem derartigen Aufbau besteht jedoch die Gefahr von unerwünschten Koppeleffekten zwischen Teilen benachbarter Meßkanäle.

Der Erfindung liegt nun die Aufgabe zugrunde, eine Vorrichtung zur Messung schwacher Magnetfelder anzugeben, die bei einer Vielzahl von Gradiometern und einer entsprechenden Anzahl von DC-SQUIDs einen einfachen Aufbau mit einer verhältnismäßig geringen Anzahl von Anschlüssen und zugleich eine dichte Packung der Dünnfilmstrukturen ermöglicht und dennoch ein Übersprechen der einzelnen Meßkanäle verhindert.

Diese Aufgabe wird erfindungsgemäß gelöst mit den kennzeichnenden Merkmalen des Anspruchs 1.

Aufgrund der Ausgestaltung der erfindungsgemäßen Meßvorrichtung mit diesen Merkmalen werden durch die galvanische Kopplung von n Dünnfilmstrukturen n Signalleitungen und auch n sogenannte BIAS-Leitungen eingespart. Damit wird die Zahl der Leitungsverbindungen erheblich vermindert. In gleicher Weise werden durch die galvanische Kopplung von n Modulationsleitungen auch n Anschlußkontakte eingespart. Durch die galvanische Kopplung aller Koppelspulen werden n Transformatorleitungen und somit auch n Anschlußkontakte eingespart.

Durch die Anordnung der an sich bekannten (EP-A 0 111 827) geschlossenen supraleitenden Abschirmringe, die jeweils einer der aus dem DC-SQUID mit ihrer Koppel- sowie Modulationsspule gebildeten Baueinheit zugeordnet sind, ergibt sich eine magnetische Entkopplung, die ein Übersprechen der einzelnen Kanäle verhindert. Durch die Ausbildung der gemeinsamen SQUID- und Koppelspulenanschlüsse jeweils als großflächige Dünnfilme, die unter der Bezeichnung Groundplanes bekannt sind, werden die Spulen-Anschlüsse magnetisch voneinander entkoppelt. Unter einer Groundplane wird also nachfolgend ganz allgemein eine flächenhafte Dünnfilmstruktur verstanden, die auf einem beliebigen Potential liegen kann.

Das gemeinsame Substrat kann beispielsweise aus Keramik, vorzugsweise aus Halbleitermaterial, insbesondere aus Silizium, bestehen und enthält vorzugsweise auch noch jeweils einen Anschlußkontakt für die gemeinsame Signalleitung sowie gemeinsame BIAS-Leitung der DC-SQUIDs und kann außerdem auch noch einen gemeinsamen Anschluß für die Rückleitungen der Gradiometer enthalten. Diese elektrischen Anschlüsse werden im allgemeinen als flächenhafte Anschlußkontakte, sogenannte Kontaktpads ausgeführt, die eine Leitungsverbindung, insbesondere der normalleitenden Verbindungen, durch Bonden ermöglichen. Das Substrat kann vorzugsweise in eine Printplatte eingesetzt werden, die im allgemeinen aus Glasfaser-Kunststoff besteht und mit einem Muster von Leiterbahnen versehen ist und die eine entsprechende Aussparung enthält. Auf dieser Printplatte kann zweckmäßig zugleich ein Teil der Elektronik, beispielsweise Filter und Vorverstärker, angeordnet werden. Durch die gleichzeitige Signalerfassung und parallele Signalverarbeitung ergibt sich eine entsprechend verminderte Zeit zur Registrierung physiologischer Magnetfelder.

Eine zusätzliche Abschirmwirkung erhält man dadurch, daß das als Chip dienende Substrat auf einer supraleitenden Grundplatte angeordnet wird. Damit erhält man zugleich eine magnetische Entkopplung der einander benachbarten Kontaktpads. In einer bevorzugten Ausführungsform kann das Substrat auf seiner unteren Flachseite mit einer dünnen supraleitenden Auflage versehen werden, die auch noch den angrenzenden Oberflächenbereich der Printplatte bedeckt und vorzugsweise als Groundplane ausgeführt werden kann.

Die normalleitenden Anschlüsse des Substrats können in bekannter Weise durch Bonden mit den Kupferleitbahnen der Printplatte verbunden werden. Diese Verbindungsleiter werden durch die supraleitende Grundplatte magnetisch entkoppelt.

Für die supraleitenden Anschlüsse der Flußtransformatoren kann eine lösbare Leitungsverbindung vorgesehen sein, die vorzugsweise als Steckkontakt, insbesondere als Ringkontakt, ausgeführt sein kann.

Ferner kann zur Verbindung der supraleitenden Anschlüsse des Gradiometers mit den Kontaktpads des SQUID-Arrays eine Vielzahl von Druckkontakten vorgesehen sein, die als Federkontakte gestaltet sein können. Besonders geeignet ist ein kompaktes Paket von supraleitenden Kontaktfedern, ein sogenannter Kontaktkamm. Durch diese Kontaktfedern, deren Dicke durch den Abstand der Kontaktpads auf dem Halbleitersubstrat gegeben ist und die durch eine elektrisch isolierende Auflage oder Zwischenlage gegeneinander isoliert sind, wird in besonders einfacher Weise ein Druckkontakt zwischen den supraleitenden Anschlüssen des Chips und den Zu- und Ableitungen der Gradiometerspulen hergestellt. Da diese Kontaktfedern bereits mit dem Abstand der Kontaktpads auf dem Substrat nebeneinander angeordnet sind und eine kompakte Baueinheit bilden, kann der Kontaktkamm in einfacher Weise durch Verschieben justiert und anschließend beispielsweise durch Verschrauben in seiner Lage fixiert werden. Die supraleitende Grundplatte wird dann vorzugsweise so ausgeführt, daß sie auch noch unterhalb des Kontaktkamms angeordnet ist und somit diese supraleitenden Anschlüsse ebenfalls magnetisch entkoppelt.

Zur weiteren Erläuterung der Erfindung wird auf die Zeichnung Bezug genommen, in deren Figur 1 der Aufbau einer Vorrichtung nach der Erfindung schematisch veranschaulicht ist. Figur 2 zeigt eine Ausführungsform mehrerer SQUIDs mit ihren Koppel- und Modulationsspulen als Baueinheiten in Dünnfilmstruktur mit ihrer galvanischen Kopplung und magnetischen Entkopplung. In den Figuren 3 und 4 ist der Schichtaufbau eines der SQUIDs in Dünnfilmstruktur schematisch angedeutet.

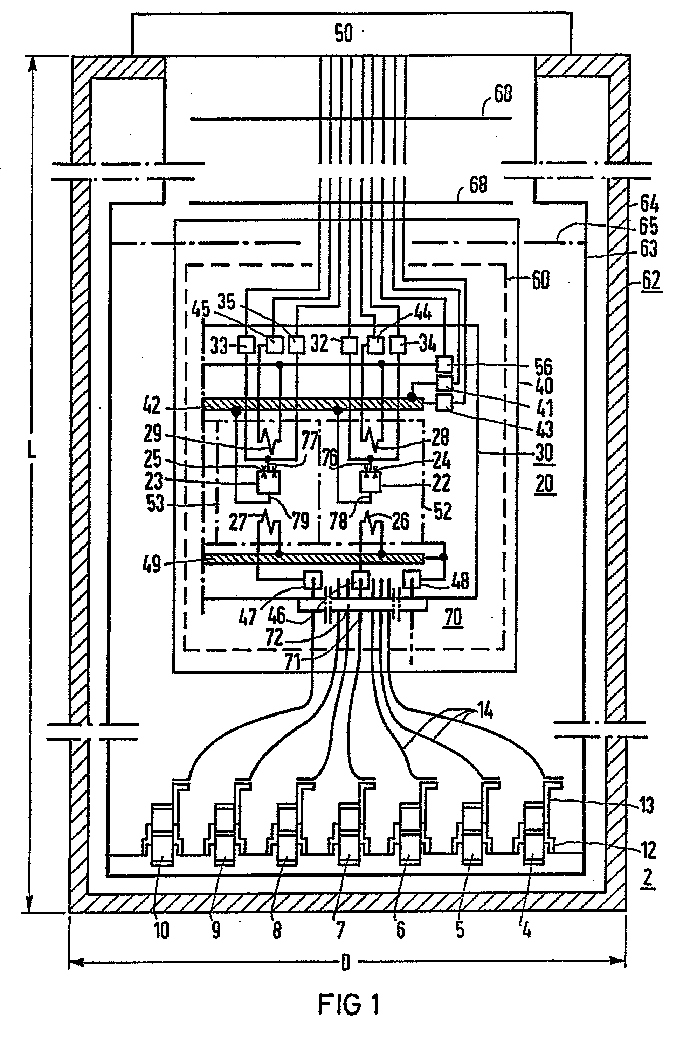

In der Ausführungsform einer Vorrichtung zur Messung schwacher Magnetfelder nach Figur 1 ist ein Gradiometer-Array 2 vorgesehen, das eine Vielzahl von Gradiometern, beispielsweise wenigstens 30 Gradiometer, enthält, von denen in der Figur zur Vereinfachung nur 7 angedeutet und mit 4 bis 10 bezeichnet sind. Sie können beispielsweise Gradiometer zweiter Ordnung sein, deren nicht näher bezeichnete Detektorspulen in bekannter Weise mit ihren zugeordneten Kompensationsspulen in drei Ebenen übereinander angeordnet sind. Diese Gradiometer 4 bis 10 können jeweils in eine getrennte Halterung 12 eingesetzt sein, die beispielsweise aus einem Profilring aus Kunststoff, insbesondere Tetrafluoräthylen (Teflon), bestehen kann. Die Gradiometer 4 bis 10 sind jeweils mit Kontaktvorrichtungen für die Anschlußleiter versehen, die als Anschlußfahnen 13 dargestellt sind, an denen ihre elektrischen Zuleitungen 14 befestigt sind, deren Rückleiter in der Figur zur Vereinfachung nicht dargestellt sind. Diese supraleitenden Anschlußleiter können in bekannter Weise jeweils in einer Kapillare geführt sein.

Den Gradiometern 4 bis 10 sind entsprechende einzelne Meßkanäle zugeordnet, die jeweils ein SQUID in der Ausführungsform als DC-SQUID enthalten. Mit beispielsweise 30 Gradiometern und entsprechend 30 SQUIDs können diese SQUIDs beispielsweise in drei Gruppen aufgeteilt sein, die jeweils ein SQUID-Array 20 mit 10 SQUIDS bilden. Von diesen 10 SQUIDs sind in der Figur nur zwei zur besseren Übersicht als schematische Schaltung dargestellt und mit 22 und 23 bezeichnet. Diese SQUIDs enthalten in ihrer Ausführungsform als DC-SQUIDs bekanntlich jeweils zwei Josephsonkontakte 24 bzw. 25, die mit ihrer zugeordneten Koppelspule 26 bzw. 27 sowie einer Modulationsspule 28 bzw. 29 jeweils als Baueinheit auf einem gemeinsamen Halbleitersubstrat 30 angeordnet sind, das vorzugsweise aus Silizium bestehen kann. Die Baueinheiten sind als getrennte planare Dünnfilmstrukturen ausgeführt, deren elektrisch leitende Teile jeweils durch elektrisch isolierende Zwischenlagen getrennt sind. Für die SQUIDs 22 und 23 ist jeweils eine magnetische Entkopplung vorgesehen, die aus einem supraleitenden Ring 52 bzw. 53 besteht, der strichpunktiert angedeutet ist und in der dargestellten Ausführungsform eine gemeinsame Baueinheit für das SQUID-Array 20 bildet, jedoch auch aus getrennten supraleitenden Ringen bestehen kann.

Das Halbleitersubstrat 30 kann vorzugsweise in einer entsprechend bemessenen und in der Figur nicht näher bezeichneten Aussparung einer Printplatte 40 angeordnet sein, die in an sich bekannter Weise auf ihrer oberen Flachseite mit einem in der Figur nicht dargestellten Muster von Leiterbahnen versehen ist.

Die gemeinsamen Anschlußleiter 76 und 77 der SQUIDs 22 bzw. 23 sind jeweils mit Kontaktpads 32 bzw. 33 für den Anschluß der Signalleitungen und getrennten Kontaktpads 34 bzw. 35 für den Anschluß der BIAS-Leitungen versehen. Die gemeinsamen Rückleitungen 78 und 79 können vorzugsweise als flächenhafter Dünnfilmkontakt, insbesondere als Groundplane 42, ausgeführt sein, der in der Figur lediglich als breiter Streifenkontakt angedeutet und mit einem Kontaktpad 43 für die Signal-Rückleitung und einem weiteren Kontaktpad 41 für die BIAS-Rückleitung versehen ist. Die galvanisch gekoppelten Anschlüsse der Koppelspulen 26 und 27 können vorzugsweise ebenfalls als Groundplane 49 ausgeführt und mit einem Kontaktpad 48 versehen sein. Die Kontaktpads für die Modulationsspulen 28 und 29 sowie die Koppelspulen 26 und 27 sind in der Figur mit 44 bis 47 bezeichnet. Die Signal- und BIAS-Leitungen der SQUIDs 22 und 23 sowie der Modulationsspulen 28 und 29 sind über nicht näher bezeichnete elektrische Leiter mit einer Elektronik 50 verbunden, welche in bekannter Weise die erforderlichen Vorverstärker sowie Lock-in-Verstärker für die SQUIDs 23 und 26 und außerdem das Daten- und Steuersystem für das SQUID-Array 20 enthält. Dieser Elektronik 50 ist im allgemeinen noch eine in der Figur nicht dargestellte Ausgabeeinheit zugeordnet.

Unter Umständen kann es zweckmäßig sein, auch die galvanisch gekoppelten Anschlüsse der Modulationsspulen 28 und 29, die mit einem Kontaktpad 56 verbunden sind, als Groundplane auszuführen. Die supraleitenden Abschirmringe 52 und 53 können beispielsweise an das Kontaktpad 48 angeschlossen sein, mit dem auch die in der Figur nicht dargestellten Rückleitungen der Gradiometer 4 bis 10 verbunden sind.

Für das SQUID-Array 20 mit seinen Kontaktpads, insbesondere seinen supraleitenden Anschlüssen, ist noch eine zusätzliche magnetische Abschirmung vorgesehen, die aus einem flachen supraleitenden Grundkörper 60 besteht, der mit dem Halbleitersubstrat 30 formschlüssig verbunden, beispielsweise verklebt, ist. Dieser Grundkörper 60 ist unterhalb der Printplatte 40 angeordnet und deshalb in der Figur gestrichelt angedeutet. Seine Ausdehnung ist so gewählt, daß er auch noch unterhalb der Kontaktpads und der angrenzenden Teile der Anschlußleiter der Printplatte 40 angeordnet ist und somit auch noch für diese Teile der Anschlußleiter als magnetische Abschirmung dient.

Zur elektrischen Verbindung des Gradiometer-Arrays 2 mit dem SQUID-Array 20 kann vorzugsweise eine lösbare Leitungsverbindung vorgesehen sein, die beispielsweise aus einer in der Figur nicht dargestellten Vielfach-Steckverbindung mit zwei Ringkontakten bestehen kann. In einer bevorzugten Ausführungsform kann als Leitungsverbindung 70 für die supraleitenden Anschlüsse des SQUID-Arrays 20 ein Kontaktkamm mit Federkontakten 71 vorgesehen sein, die zwischen den Kontaktpads 46, 47 und 49 des SQUID-Arrays 20 und den einzelnen Anschlußleitern 14 des Gradiometer-Arrays 2 jeweils einen Druckkontakt herstellen. Die supraleitenden Verbindungsleiter 14 für die Gradiometer werden dann jeweils mit einer der Kontaktfedern verbunden. Der Kontaktkamm wird mittels einer gemeinsamen Druckplatte 72 auf die Kontaktpads des Halbleitersubstrats 30 aufgedrückt. In der praktischen Ausführungsform des Kontaktkamms sind die Federkontakte 71 ohne wesentlichen Abstand, jedoch gegeneinder elektrisch isoliert nebeneinander angeordnet.

Die Gradiometer 4 bis 10 des Gradiometer-Arrays 2 sind mit dem SQUID-Array 20 in bekannter Weise in einem doppelwandigen Dewar-Gefäß 62 angeordnet, dessen Innenbehälter mit 63 und dessen Außenbehälter mit 64 bezeichnet ist. Das Dewar-Gefäß 62 ist bis oberhalb des SQUID-Arrays 20 mit flüssigem Helium gefüllt, dessen Oberflächenspiegel 65 in der Figur strichpunktiert angedeutet ist. Das Gradiometer-Array 2 und das SQUID-Array 20 werden somit während des Betriebes der Vorrichtung auf kryogener Temperatur gehalten. Im Zwischenraum zwischen dem Innen- und Außenbehälter ist im allgemeinen eine in der Figur nicht dargestellte Superisolation vorgesehen. Zwischen dem SQUID-Array 20 und der Elektronik 50 sind mehrere Strahlungsschilde 68 angeordnet.

In der praktischen Ausführungsform der Vorrichtung zur Messung schwacher Magnetfelder kann die Länge L der gesamten Anordnung beispielsweise mehr als 100 cm betragen und die Printplatte 40 oder mehrere parallel zueinander angeordnete Printplatten können innerhalb des Dewar-Gefäßes 62 befestigt werden.

In der Ausführungsform der Vorrichtung zur Magnetokardiographie kann der Durchmesser D an dem das Gradiometer-Array 2 enthaltenden Ende beispielsweise etwa 30 cm betragen. Für besondere Ausführungsformen, wie sie beispielsweise zur Magnetoenzophalographie verwendet werden, kann unter Umständen ein gebogenes Array verwendet werden, dessen Form etwa einer Kugelkalotte angenähert ist und dessen Innendurchmesser etwa 20 cm betragen kann. Diese Ausführungsform mit einer lösbaren Leitungsverbindung zwischen dem Gradiometer-Array 2 und dem SQUID-Array 20 hat den Vorteil, daß das gesamte Gradiometer-Array 2 als Steckmodul ausgeführt werden kann.

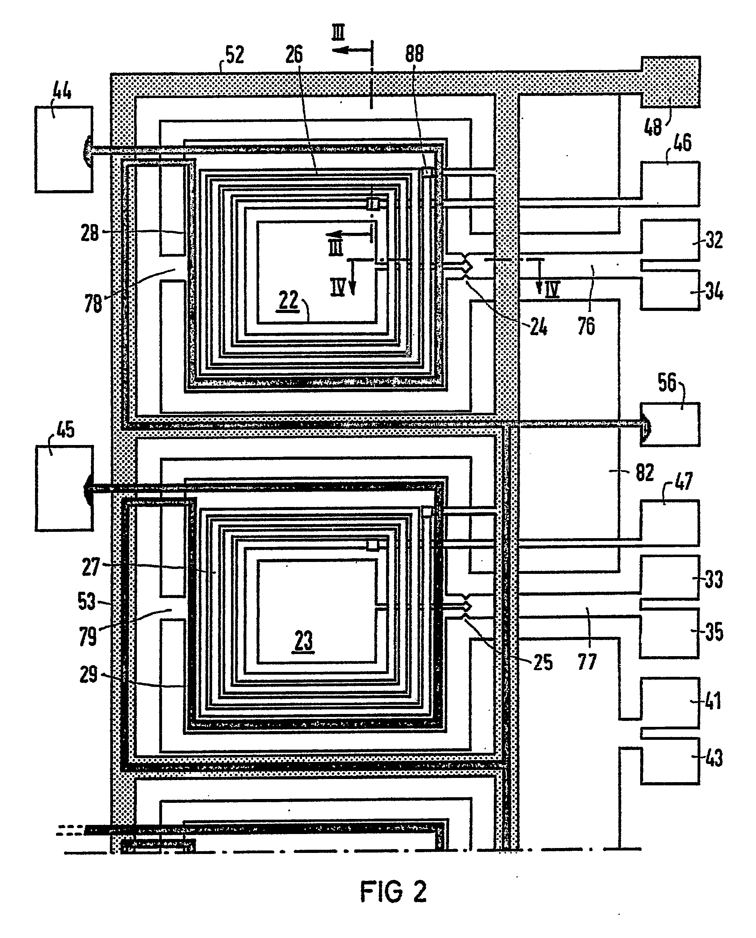

In der Ausführungsform des SQUID-Arrays 20 nach Figur 2 sind aus der Vielzahl von DC-SQUIDs mit ihren Josephson-Kontakten sowie ihren Koppelspulen und Modulationsspulen entsprechend der Figur 1 nur zwei dargestellt und mit 22 und 23 bezeichnet. Sie sind jeweils als Baueinheit in Dünnfilmtechnik auf dem nicht dargestellten Substrat angeordnet. Eine zur gegenseitigen elektrischen Isolierung elektrisch leitender Teile der Dünnfilmstrukturen erforderliche elektrisch isolierende Zwischenlage, die vorzugsweise aus Siliziumoxid SiO oder Siliziumdioxid SiO₂ bestehen kann, ist in der Figur zur Vereinfachung ebenfalls nicht dargestellt. Die als Signal- und BIAS-Leitung gemeinsame breite Zuleitung 76 bzw. 77 führt jeweils über die beiden Josephson-Kontakte 24 bzw. 25 zu dem entsprechenden Halbring der SQUIDs 22 bzw. 23 und vom Ende der Halbringe wiederum mit einem großflächigen Anschlußleiter 78 bzw. 79 zu einer Groundplane 82.

Die Zuleitungen von den Kontaktpads 46 47 zu den Koppelspulen 26 bzw. 27 sind jeweils über die Groundplane 82 geführt, die somit für diesen Leitungsabschnitt als magnetische Abschirmung dient. Von den Kontaktpads 44 und 45 führt jeweils eine Zuleitung zu den Modulationsspulen 28 bzw. 29, die jeweils konzentrisch zu den Koppelspulen 26 bzw. 27 und zu den SQUIDs 22 bzw. 23 angeordnet sind. Für die gemeinsame Rückleitung aller Modulationsspulen ist das Kontaktpad 56 vorgesehen. Den Baueinheiten in Dünnfilmstruktur mit den SQUIDs 22 und 23 und den ihnen zugeordneten Koppelspulen 26 bzw. 27 sowie Modulationsspulen 28 bzw. 29 ist jeweils einer der Abschirmringe 52 und 53 zugeordnet, die in der dargestellten Ausführungsform vereinigt sind, jedoch auch in getrennte Ringe aufgeteilt sein können. Diesen Abschirmringen 52 und 53 kann vorzugsweise ein gemeinsames Kontaktpad 48 zugeordnet sein, an das sie über eine nicht näher bezeichnete Verbindungsleitung angeschlossen sind.

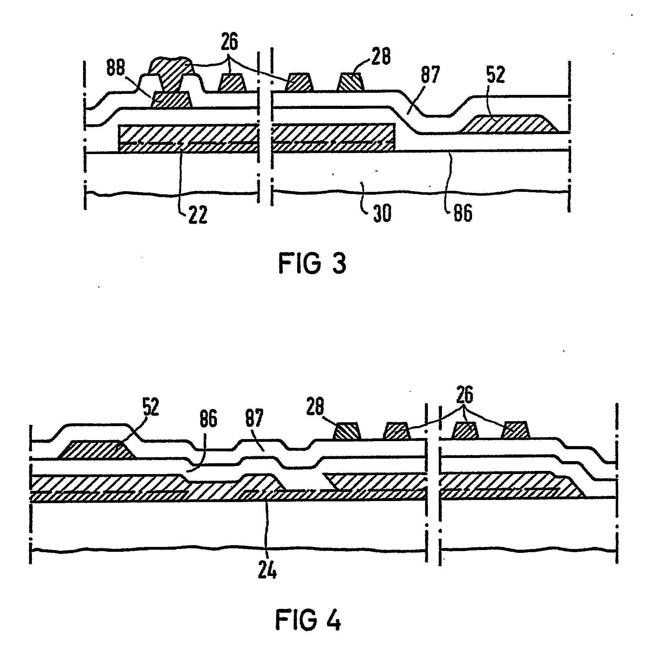

Alle Baueinheiten des SQUID-Arrays 20 mit ihren DC-SQUIDs auf den Substrat 30 werden gemeinsam in Dünnfilmtechnik hergestellt. Wie im Schnitt der Figur 3 für nur eine der Baueinheiten schematisch angedeutet, werden für die einzelnen SQUIDs mit ihren Josephson-Kontakten zunächst Doppelschichten aus einem supraleitenden Metall, vorzugsweise Niob, abgeschieden, von denen die erste Schicht beispielsweise eine Dicke von etwa 100 nm und die zweite Schicht etwa die doppelte Dicke hat. In der Figur ist lediglich die Doppelschicht für das SQUID 22 dargestellt und durch eine strichpunktierte Trennungslinie angedeutet. Im folgenden Arbeitsgang werden die SQUIDs durch eine großflächige Isolationsschicht 86 abgedeckt, die vorzugsweise aus Siliziumoxid SiO oder Siliziumdioxid SiO₂ bestehen kann und mit Aussparungen für die Kontaktpads versehen ist. Anschließend erfolgt die Metallisierung für den Abschirmring 52 und die Anschlüsse der Koppelspule 26, von denen in der Figur der Innenanschluß 88 sichtbar ist sowie eine in der Figur nicht sichtbare metallische Abdeckung für den Spalt zwischen den beiden SQUID-Halbringen. Die Koppelspule 26 selbst liegt in einer höheren Ebene. Im dritten Arbeitsgang werden diese Metallisierungen durch eine weitere Isolationsschicht 87 abgedeckt, die mit Öffnungen für die Spulenanschlüsse versehen ist. Dann werden in einem gemeinsamen Arbeitsgang die Koppelspule und die Modulationsspule 28 mit beispielsweise einer einzigen Windung aufgebracht. Abweichend von der dargestellten Ausführungsform kann der Abschirmring 52 vorzugsweise als Groundplane ausgebildet sein.

Im Schnitt nach Figur 4 ist außer den Windungen der Koppelspule 26 sowie der Modulationsspule 28 und dem Abschirmring 52 mit den Isolationsschichten 86 und 87 noch der Aufbau eines der Josephson-Elemente 24 angedeutet, deren Tunnelbarriere vorzugsweise im sogenannten Schwebemaskenverfahren hergestellt werden kann, wie es beispielsweise aus "Fabrication and Charakterization of thermally recyclable submicron Niobium-Niobium Josephson Junctions" in SQUID '80, W.d.Gruyter & Co., Berlin - New York, May 1980, Seiten 399 bis 415, bekannt ist.

## Patentansprüche

1. Vorrichtung zur mehrkanaligen Messung schwacher Magnetfelder, welche Vorrichtung ein Gradiometer-Feld (2) mit einer Vielzahl von Gradiometern (4 bis 10) sowie ein an das Gradiometer-Feld (2) angekoppeltes, auf einem Substrat (30) befindliches Interferometer-Feld (20) mit einer Vielzahl von supraleitenden Gleichstrom-Quanteninterferometern (22, 23) enthält, die jeweils zwei Josephson-Kontakte (24, 25) aufweisen und denen jeweils eine Koppelspule (26, 27) sowie eine Modulationsspule (28, 29) zugeordnet sind, dadurch gekennzeichnet, daß

  – jedes Interferometer (22, 23) des Interferometer-Feldes (2) zusammen mit der ihm zugeordneten Koppelspule (26, 27) und der ihm zugeordneten Modulationsspule (28, 29) eine gesonderte, als Dünnfilmstruktur ausgebildete Baueinheit bildet,
  – alle Baueinheiten gemeinsam auf dem Substrat (30) angeordnet sind,
  – für eine magnetische Entkopplung der Baueinheiten jede Baueinheit von einem supraleitenden Abschirmring (52, 53) umgeben ist,
  – für wenigstens einen Teil der gemeinsamen Anschlüsse der Baueinheiten eine galvanische Kopplung durch flächenhafte Dünnfilmstrukturen (42, 49) vorgesehen ist, und
  – eine zusätzliche gemeinsame magnetische Abschirmung für alle Baueinheiten einschließlich ihrer Anschlußleiter vorgesehen ist, die aus einem flächenhaften supraleitenden Grundkörper (60) besteht, der mit einer Flachseite des Substrates (30) formschlüssig verbunden ist.

2. Vorrichtung nach Anspruch 1, dadurch gekennzeichnet, daß die gemeinsamen elektrischen Rückleitungen der Interferometer (22, 23) als flächenhafte Dünnfilmstruktur (42) gestaltet sind.

3. Vorrichtung nach Anspruch 1 oder 2, dadurch gekennzeichnet, daß für die gemeinsamen elektrischen Rückleitungen der Koppelspulen (26 bzw. 27) eine flächenhafte Dünnfilmstruktur (49) vorgesehen ist.

4. Vorrichtung nach Anspruch 1 bis 3, dadurch gekennzeichnet, daß das Substrat (30) in einer Öffnung einer Printplatte (40) angeordnet ist und daß die Ausdehnung der Flachseiten des supraleitenden Grundkörpers (60) wesentlich größer ist als die Öffnung der Printplatte (40), so daß der Grundkörper (60) auch noch wenigstens teilweise unterhalb der supraleitenden Zu- und Rückleitungen des Interferometer-Feldes (20) angeordnet ist.

5. Vorrichtung nach einem der Ansprüche 1 bis 4, dadurch gekennzeichnet, daß der supraleitende Grundkörper (60) als flächenhafte Dünnfilmstruktur gestaltet ist und unter dem Substrat (30) angeordnet ist.

6. Vorrichtung nach einem der Ansprüche 1 bis 5, dadurch gekennzeichnet, daß für die supraleitenden Verbindungsleiter (14) zwischen dem Interferometer-Feld (20) und dem Gradiometer-Feld (2) eine lösbare Leitungsverbindung (70) vorgesehen ist.

## Claims

1. Apparatus for the multichannel measurement of weak magnetic fields, which apparatus comprises a gradiometer array (2) having a plurality of gradiometers (4 to 10) and an interferometer array (20) coupled to the gradiometer array (2) and disposed on a substrate (30) and having a plurality of superconducting direct current quantum interferometers (22, 23), each of which has two Josephson contacts (24, 25) respectively and with each of which a coupling coil (26, 27) and a modulation coil (28, 29) are associated, characterised in that
- each interferometer (22, 23) of the interferometer array (20) forms, together with its associated coupling coil (26, 27) and its associated modulation coil (28, 29), a separate modular unit designed as a thin-film structure,
- all modular units are arranged together on the substrate (30),
- each modular unit is surrounded by a superconducting shielding ring (52, 53) serving for the magnetic decoupling of the modular units,
- galvanic coupling by means of planar thin-film structures (42, 49) is provided for at least a part of the common connections of the modular units, and
- additional common magnetic shielding for all the modular units including their connecting conductors is provided which consists of a planar superconducting base body (60) connected in a form-locking manner to a flat side of the substrate (30).

2. Apparatus according to claim 1, characterised in that the common electric return lines of the interferometers (22, 23) are designed as a planar thin-film structure (47).

3. Apparatus according to claim 1 or 2, characterised in that a planar thin-film structure (49) is provided for the common electric return lines of the coupling coils (26 or 27).

4. Apparatus according to claim 1 to 3, characterised in that the substrate (30) is arranged in an opening of a printed circuit board (40) and in that the extent of the flat sides of the superconducting base body (60) is substantially larger than the opening of the printed circuit board (40), so that the base body (60) is still arranged, at least partially, below the superconducting feed and return lines of the interferometer array (20).

5. Apparatus according to one of claims 1 to 4, characterised in that the superconducting base body (60) is designed as a planar thin-film structure and is arranged below the substrate (30).

6. Apparatus according to one of claims 1 to 5, characterised in that a detachable line connection (70) is provided for the superconducting connecting conductors (14) between the interferometer array (20) and the gradiometer array (2).

## Revendications

1. Dispositif de mesure à canaux multiples de champs magnétiques faibles, lequel dispositif comporte un champ de gradiomètres (2) qui présente une multiplicité de gradiomètres (4 à 10) ainsi qu'un champ d'interféromètres (20) qui présente une multiplicité d'interféromètres quantiques (22, 23) à courant continu situés sur un substrat (30) et qui est couplé avec le champ de gradiomètres (2), lesdits interféromètres quantiques (22, 23) comportant chacun deux contacts de Josephson (24, 25) et à chacun d'eux sont associées une bobine de couplage (26, 27) ainsi qu'une bobine de modulation (28, 29), caractérisé par le fait que
- chaque interféromètre (22, 23) du champ d'interféromètres (20) forme, avec la bobine de couplage (26, 27) qui lui est associée et avec la bobine de modulation (28, 29) qui lui est associée une unité de construction distincte, réalisée en structure à couche mince,
- pour un découplage magnétique des unités de construction, chacune de celles-ci est entourée d'un anneau de blindage à supraconduction (52, 53),
- pour au moins une partie des bornes de liaison communes aux unités de construction, il est prévu un couplage galvanique par des structures à couche mince (42, 49) et à extension superficielle, et
- un blindage magnétique supplémentaire et commun pour toutes les unités de construction, y compris pour leurs conducteurs de raccordement, est prévu, ledit blindage magnétique étant constitué par un corps de base à supraconduction (60), ayant une extension superficielle, et étant relié par formes complémentaires à un côté plat du substrat (30).

2. Dispositif selon la revendication 1, caractérisé par le fait que les conducteurs électriques de retour communs des interféromètres (22, 23) sont réalisés sous la forme d'une structure à couche mince (42) et à extension superficielle.

3. Dispositif selon la revendication 1 ou 2, caractérisé par le fait que pour les conducteurs électriques de retour communs des bobines de couplage (26 et 27), est prévu une structure à couche mince et à extension superficielle.

4. Dispositif selon la revendication 1 à 3, caractérisé par le fait que le substrat (30) est disposé dans une ouverture ménagée dans un plaquette à circuits imprimés (40), et que l'extension des côtés plats du corps de base à supraconduction (60) est notablement supérieure à l'ouverture de la plaquette à circuits imprimés (40), de manière que le corps de base (60) se situe encore au moins partiellement endessous des conducteurs à supraconduction d'alimentation et de retour du champ d'interféromètres (20).

5. Dispositif selon l'une des revendications 1 à 4, caractérisé par le fait que le corps de base à supraconduction (60) est réalisé sous la forme d'une structure à couche mince et à extension superficielle et il est disposé sous le substrat (30).

6. Dispositif selon l'une des revendications 1 à 5, caractérisé par le fait qu'il est prévu une liaison détachable (70) pour les conducteurs de liaison à supraconduction (14) etre le champ d'interféromètres (20) et le champ de gradiomètres (2).

FIG 1

FIG 2

FIG 3

FIG 4